# EUROPÄISCHE PATENTANMELDUNG

(11) **EP 0 969 409 A2**
(43) Veröffentlichungstag der Anmeldung: **05.01.2000**
(21) Anmeldenummer: 99111832.4
(22) Anmeldetag: 19.06.1999
(51) Int. Cl.: G06K 19/077

(54) **Varfahren zur Herstellung einer Chipkarte sowie nach dem Verfahren hergestellte Chipkarte**

(30) Priorität: 02.07.1998 DE 19829617
(71) Anmelder: Orga Kartensysteme GmbH, 33104 Paderborn (DE)
(72) Erfinder: Isberner, Roland, 24147 Kiel (DE)

(57) **Zusammenfassung**

Es wird ein Verfahren zur Herstellung einer Chipkarte mit einem in einen Kartenkörper (1A) einzusetzenden Trägerelement (Chipmodul) beschrieben,
das aus zwei Teilen (2A,2B) besteht,
   - nämlich einem ersten Teil (2A), auf dem elektrische Kontaktflächen (20) für die Energieversorgung und den Datenaustausch des Chips (IC-Halbleiterbaustein) mit externen Geräten angeordnet sind,
   - und einem zweiten Teil (2B) in Form eines Vergußgehäuses, das den Chip und die Anschlußleitungen des Chips an die Kontaktflächen (20) aufnimmt und vor mechanischen Belastungen schützt, wobei der erste Teil (2A) über den Rand des zweiten Teils (2B) hinausragt
   - wobei das Trägerelement (2) auf der den Kontaktflächen (20) gegenüberliegenden Seite zumindest in dem Bereich, wo das erste Teil (2A) das zweite Teil (2B) randseitig überragt, eine Heißklebeschicht (6) aufweist,
   wobei der Kartenkörper (1A) eine Aussparung (4) mit einer mittig dazu liegenden Vertiefung (5) aufweist, und die Aussparung (4) um die Vertiefung (5) herum eine Auflageschulter (4A) aufweist,
   wobei das Trägerelement (2) so in den Kartenkörper (1A) eingesetzt wird, daß das erste Teil (2A) mittels der Heißklebeschicht (6) auf der Auflageschulter (4A) fixiert wird und das zweite Teil (2B) in der Vertiefung (5) Platz findet.

Erfindungsgemäß wird nun in einem ersten Schritt vor dem Einsetzten des Trägerelements (2) in die Vertiefung (5) des Kartenkörpers (1A) mittels eines Dispensers (9) ein zusätzlicher Kleber (7) zur Verbindung des Vergußgehäuses (2B) mit dem Kartenkörper (1A) eingebracht, und dann in einem zweiten Schritt das Trägerelement (2) mittels Druck und Wärme in die Aussparung (4) des Kartenkörpers (1A) eingesetzt.

## Beschreibung

Die Erfindung betrifft ein Verfahren zur Herstellung einer Chipkarte und eine nach diesem Verfahren hergestellte Chipkarte.

Eine derartige Chipkarte ist beispielsweise aus der DE 41 26 874C1 bekannt. Chipkarten werden u.a. als Krankenversichertenkarten, Geldkarten, Kreditkarten, Zugangsberechtigungskarten für das (GSM-Mobilfunknetz und als Telefonkarten eingesetzt.

Chipkarten dieser Art weisen ein Trägerelement (ein sogenanntes Chipmodul) auf, das in eine Aussparung des Kartenkörpers eingebettet (implantiert) wird. Das Trägerelement besteht aus zwei Teilen, nämlich einem ersten Teil, aufdem die elektrischen Kontaktflächen für die Energieversorgung und den Datenaustausch des Chips (integrierter Halbleiterbaustein) angeordnet sind, und einem zweiten Teil in Form eines Vergußgehäuses, das den Chip und die Anschlußleitungen des Chips an die elektrischen Kontaktflächen aufnimmt und vor mechanischen Belastungen schützt. Dabei ragt der erste Teil über den Rand des zweiten Teils hinaus. Das erste Teil besteht aus einem Kunststoffsubstrat (z.B. glasfaserverstärktes Epoxydharz) auf dem die elektrischen (metallischen) Kontaktflächen angeordnet sind. Die Aussparung im Kartenkörper zur Aufnahme des Trägerelements besitzt mittig eine Vertiefung, wobei die Aussparung um die Vertiefung herum eine Auflageschulter aufweist. Das Trägerelement ist dabei so in den Kartenkörper eingebettet, daß das erste Teil mit dem über den Rand des zweiten Teils hinausragenden Bereich mittels eines Klebers aufder Auflageschulter fixiert ist und das zweite Teil innerhalb der Vertiefung Platz findet. Zu diesem Zweck wird vor der Implantation auf das Trägerelement rückseitig (d.h. auf der den Kontaktflächen abgewandten Seite) zumindest in dem Bereich, wo das erste Teil das zweite Teil randseitig überragt eine Heißklebeschicht (Schmelzklebefolie) aufgebracht. Die Implantation des Trägerelements erfolgt dann anschließend unter dem Einfluß von Druck und Wärme mittels eines entsprechend ausgebildeten und beheizten Implantationsstempels.

Ein sehr wichtiger Aspekt hierbei ist die Haftung des Trägerelements (Chipmodul) in dem Kartenkörper. Dabei darf das Trägerelement auch bei extremen Biegebelastungen nicht aus dem Kartenkörper herausfallen, sondern muß sicher in dem Kartenkörper fixiert sein. Da derartige Karten durchaus mehrere Jahre im Einsatz sein können, muß sichergestellt sein, daß die Haftung über diesen Zeitraum sich nicht derart verschlechtert, daß eine sichere Fixierung nicht mehr gewährleistet ist. Es hat sich gezeigt, daß Chipkarten der vorstehend genannten Art sehr hohen Anforderungen an die Haftung nicht entsprechen.

Ein weiterer wichtiger Aspekt ist der Schutz vor Mißbrauch in Verbindung mit Chipkarten. Der eigentlich sicherheitsrelevante Datenträger ist hier der Chip. Die vorstehend beschriebenen Chipkarten haben den Nachteil, daß es möglich ist, das Trägerelement ohne Zerstörung desselben mutwillig aus dem Kartenkörper herauszulösen - z.B. durch kräftiges 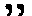 Knibbeln" und ggf. den Einsatz von Chemikalien, die die Klebewirkung der Heißklebeschicht zwischen Trägerelement und Auflageschulter des Kartenkörpers beeinträchtigen. Die Tatsache, daß das Trägerelement mit dem Chip als dem eigentlichen sicherheitsrelevanten Datenträger der Karte aus dem Kartenkörper beschädigungsfrei herausgelöst werden kann und dann in einen anderen Kartenkörper eingesetzt werden kann, bedeutet ein hohes Sicherheitsrisiko.

Insbesondere bei personenbezogenen Karten, z.B. Bankkarten oder Krankenversichertenkarten, werden allerdings aus sicherheitsgründen bestimmte Informationen (z.B. Name, Photo etc.) zusätzlich sichtbar aufden Kartenkörper aufgebracht. Allerdings ist die Herstellung eines gefälschten Kartenkörpers vergleichsweise einfach. Damit besteht die Gefahr, daß mutwillig aus echten Karten herausgelöste Trägerelemente (Chipmodule) in gefälschte Karten eingesetzt werden.

Es ist daher die Aufgabe der Erfindung, ein Verfahren zur Herstellung einer Chipkarte mit Trägerelement zu entwickeln, so daß die Haftung des Trägerelements in dem Kartenkörper vergrößert wird und ferner ein beschädigungsfreies Heraustrennen des Trägerelements aus dem Kartenkörper nicht möglich ist.

Diese Aufgabe wird erfindungsgemäß durch die kennzeichnenden Merkmale des Patentanspruches 1 gelöst.

Erfindungsgemäß wird in einem ersten Schritt vor dem Einsetzen des Trägerelements in die Vertiefung des Kartenkörpers mittels eines Dispensers ein zusätzlicher Kleber zur Verbindung des Vergußgehäuses mit dem Kartenkörper eingebracht. Die Implantation des Trägerelements in die Aussparung erfolgt danach unter Druck und Wärme zur Aktivierung der Heißklebeschicht.

Durch den erfindungsgemäß eingebrachten Kleber wird die Haftung des Trägerelements (Chipmoduls) im Kartenkörper erheblich vergrößert, wodurch die Zuverlässsigkeit der so hergestellten Chipkarten deutlich verbessert wird.

Darüber hinaus wird das Trägerelement (Chipmodul) erfindungsgemäß quasi 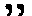 verplombt" in den Kartenkörper eingeheftet, da aufgrund der zusätzlichen Klebeverbindung beim Heraustrennen des Trägerelements aus dem Kartenkörper eine irreparable Zerstörung des Trägerelements, insbesondere des Vergußgehäuses, bewirkt wird.

Sollte beispielsweise versucht werden, das Trägerelement aus dem Kartenkörper herauszureißen, so würden über die zusätzliche Klebeverbindung so große Spannungen auf das Vergußgehäuse ausgeübt, daß in der Folge davon dasselbe Reißen bzw. Brechen würde. Dies würde wiederum unweigerlich zu einem Abreißen der Anschlußleitungen zwischen Chip und Kontaktflächen führen, wodurch das Trägerelement (Chipmodul) unbrauchbar wird. Auch wenn der Chip selbst dabei unversehrt bleiben sollte, ist es nicht mehr oder nur noch mit sehr großem Aufwand in Speziallabors möglich, diesen erneut in einem Trägerelement zu verpacken. Außerdem hätte ein derartiger Versuch, das Trägerelement aus dem Kartenkörper zu lösen, zur Folge, daß die nur hauchdünne Rückseite des Kartenkörpers im Bereich der Vertiefung aufreißt, so daß auch der Kartenkörper unbrauchbar ist. Für Betrüger kommt dabei erschwerend hinzu, daß an dem Vergußgehäuse des Trägerelements dann auch noch Kleberbestandteile und/oder Teile der Kartenkörperrückseite haften, die schwer abzutrennen sind; ohne deren Abtrennung ist allerdings das Wiedereinsetzen des Trägerelements nicht möglich.

Auf den beigefügten Zeichnungen soll die Erfindung nachfolgend näher erläutert werden. Es zeigt:
- Fig.1: eine Draufsicht auf eine Chipkarte,
- Fig.2: einen stark vergrößerten, nicht maßstäblichen Schnitt durch die erfindungsgemäße Chipkarte im Bereich des Trägerelements,
- Fig.2A: einen Schnitt durch das Trägerelement und den Kartenkörper nach dem gewaltsamen Trennen der beiden Komponenten,
- Fig.3: eine Draufsicht aufden Kartenkörper mit einem Loch in der Vertiefung,
- Fig.4: einen Schnitt durch den Kartenkörpermit Aussparung,
- Fig.4A: einen Schnitt durch den Kartenkörpermit erfindungsgemäß eingebrachtem Kleber,
- Fig.4B: das Trägerelement und den Kartenkörper unmittelbar vor der Implantation des Trägerelements,
- Fig.4C: den Kartenkörper mit implantiertem Trägerelement.

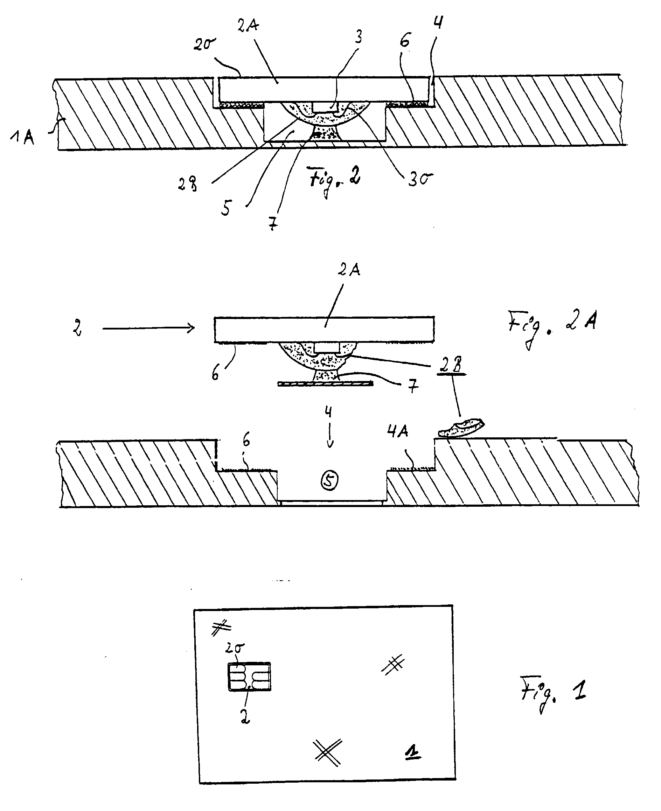

In Fig.1 ist die Draufsicht aufeine normgemäße Chipkarte (1) mit dem implantierten Trägerelement (2) und den darauf befindlichen elektrischen Kontaktflächen (20) gezeigt.

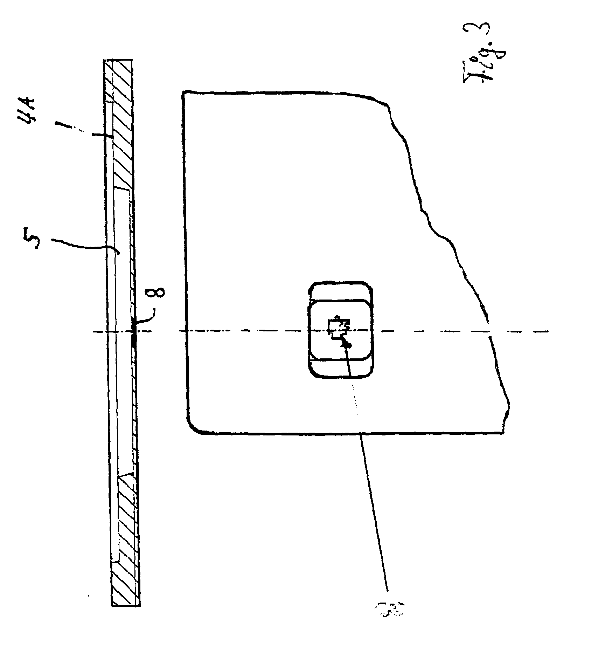

In Fig.2 ist ein Schnitt durch die Chipkarte (1) im Bereich des Trägerelements (2) gezeigt. Das Trägerelement (im folgenden wird hierfür immer der geläufige Begriff 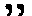 Chipmodul" verwendet) besteht aus zwei Teilen. Aufdem ersten Teil (2A) sind die Kontaktflächen (20) angeordnet. Das zweite Teil (2B), welches auf dem ersten Teil (2A) befestigt ist, ist in Form eines Vergußgehäuses ausgebildet und nimmt den Chip (3) und die Anschlußleitungen (30) des Chips an die Kontaktflächen (20) aufund schützt sie vor mechanischen Belastungen und vor schädlichen Umwelteinflüssen (z.B. Feuchtigkeit). Dabei ragt der erste Teil (2A) über den Rand des zweiten Teils (2B) hinaus. Der Kartenkörper (1A) besitzt eine Aussparung (4) mit einer mittig dazu liegenden Vertiefung (5), wobei die Aussparung (4) um die Vertiefung herum eine Auflageschulter (4A) aufweist. Das Chipmodul (2) ist so in den Kartenkörper (1A) eingebettet, daß der erste Teil (2A) mittels einer Heißklebeschicht (6) auf der Auflageschulter (4A) fixiert ist, während das zweite Teil (2B) - das Vergußgehäuse-innerhalb der Vertiefung (5) Platz findet. Das erste Teil (2A) des Chipmoduls (2) besteht aus einem Kunststoffsubstrat auf dem die elektrischen Kontaktflächen z.B. galvanisch aufgebracht sind. Bei diesem mit den Kontaktflächen beschichteten Kunststoffsubstrat handelt es sich um ein Zuliefererzeugnis zur Herstellung von Chipmodulen (2), die wiederum ein Zwischenprodukt bei der Herstellung von Chipkarten sind. Dabei wird das mit den Kontaktflächen beschichtete Kunststoffsubstrat als auf eine Rolle aufgewickeltes Kunststoffband angeliefert, auf dem die Kontaktflächen für eine Vielzahl von Chipmodulen vorhanden sind. Zur Herstellung von Chipmodulen werden auf dieses Kunststoffband jeweils positionsgenau die Chips aufgebracht (das sogenannte 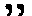 die-bonden") und dann über Anschlußleitungen (30, dünne Gold- oder Aluminiumdrähte) mit den Kontaktflächen (20) verbunden (das sogenannte 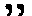 wire-bonden"). Anschließend werden dann der Chip (3) und die Anschlußleitungen (30) mit der Vergußmasse (2A) überzogen, die nachdem sie thermisch oder durch UV-Bestrahlung ausgehärtet hat, als Schutzmantel dient. In einem letzten Schritt zur Herstellung von implantierbaren und für die Massenproduktion auf einem sogenannten 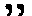 Modulband" angeordneten Chipmodulen wird dann die ebenfalls als Endlosband ausgebildete Heißklebeschicht aufdie Rückseite der Chipmodule (Rückseite des Modulbandes) - d.h. aufdie den Kontatktflächen abgewandte Seite - im Rolle/Rolle-Verfahren durch Lamination aufgebracht. Für die Implantation der Chipmodule (2) in Kartenkörper (1A) werden die aufdem Modulband angeordneten Chipmodule (2) jeweils zuvor ausgestanzt.

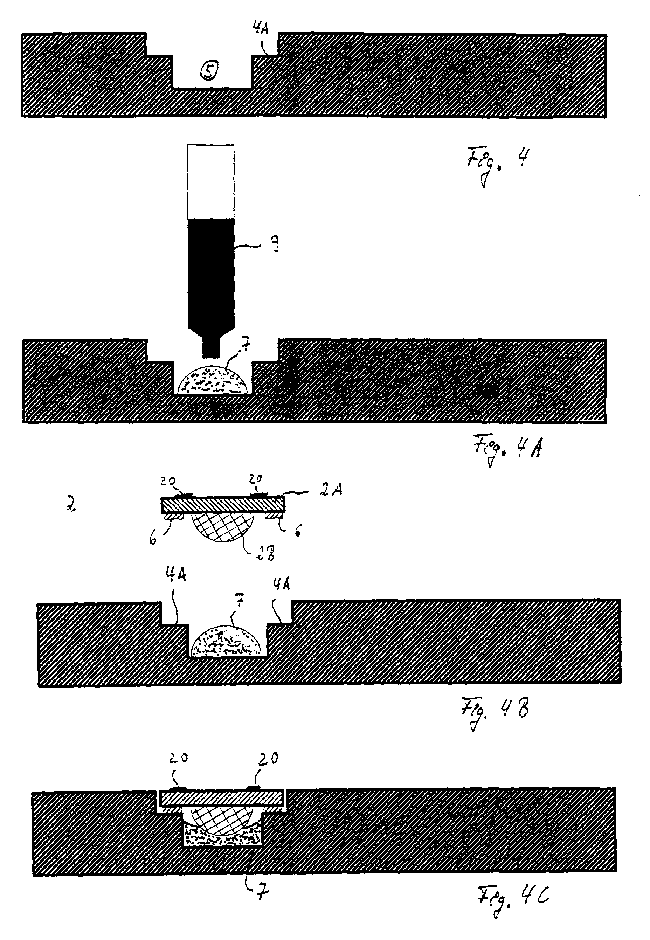

Erfindungsgemäß wird nun jeweils vor der Implantation eines Chipmoduls (2) - das wie vorstehend beschrieben hergestellt wurde - mittels eines Dispensers (9) - siehe Fig.4A - in die Vertiefung (5) der Aussparung (4) hinein ein zusätzlicher Kleber (7) eingebracht. Dabei kann ein oder mehrere Klebepunkte eingebracht werden. Als Kleber (7) wird ein vorzugsweise ein hochviskoser Kleber, bspw. ein gelartiger Kleber, verwendet. In einer Ausführungsform wird ein gelförmiger Cyanacrylat Kleber verwendet, der innerhalb von wenigen Sekunden an der Luft aushärtet. Die Verwendung eines hochviskosen Klebers hat zum einen den Vorteil, daß der bzw. die einzubringenden Klebepunkte sich besser in der Vertiefung des Kartenkörpers fixieren lassen. Darüber hinaus wird bei Verwendung eines hochviskosen Klebers - im Unterschied zu einem dünnflüssigen Kleber - vermieden, daß dieser während des Weitertransportes der Karte von der Station, wo der Kleber (7) eingebracht wird, zu der Station, wo das Chipmodul (7) implantiert wird, nicht aus der Aussparung (4) im Kartenkörper (1A) herausschwappt, was sonst aufgrund der großen Kartenbeschleunigung infolge der hohen Taktraten bei der Chipkartenproduktion unvermeidbar wäre. Die Verwendung eines hochviskosen Klebers (7) garantiert somit eine hohe Formstabilität der eingebrachten Klebemasse vor der Implantation des Chipmoduls (2).

In Figur 2A ist eine erfindungsgemäße Chipkarte gezeigt, bei der versucht wurde, Chipmodul (2) und Kartenkörper (1A) voneinander zu trennen. Wie zu erkennen ist, ist dabei das Vergußgehäuse (2B) aufgrund der zusätzlichen Klebeverbindung (7) und der infolge davon auftretenden Spannungen unter Absplittern eines Teils gebrochen. Dabei wurde auch eine der Anschlußleitungen (30) abgerissen. Das Chipmodul (2) ist somit unbrauchbar. Ferner ist zu erkennen, daß die Rückseite des Kartenkörpers (1A) im Bereich der Vertiefung (5) nunmehr ein Loch (8) aufweist - siehe auch Fig.3. Auch dieser ist dann unbrauchbar.

## Patentansprüche

1. Verfahren zur Herstellung einer Chipkarte mit einem in einen Kartenkörper (1A) einzusetzenden Trägerelement (Chipmodul),
das aus zwei Teilen (2A,2B) besteht,
- nämlich einem ersten Teil (2A), auf dem elektrische Kontaktflächen (20) für die Energieversorgung und den Datenaustausch des Chips (IC-Halbleiterbaustein) mit externen Geräten angeordnet sind,
- und einem zweiten Teil (2B) in Form eines Vergußgehäuses, das den Chip (3) und die Anschlußleitungen (30) des Chips (3) an die Kontaktflächen (20) aufnimmt und vor mechanischen Belastungen schützt, wobei der erste Teil (2A) über den Rand des zweiten Teils (2B) hinausragt
- wobei das Trägerelement (2) auf der den Kontaktflächen (20) gegenüberliegenden Seite zumindest in dem Bereich, wo das erste Teil (2A) das zweite Teil (2B) randseitig überragt, eine Heißklebeschicht (6) aufweist,
wobei der Kartenkörper (1A) eine Aussparung (4) mit einer mittig dazu liegenden Vertiefung (5) aufweist, und die Aussparung (4) um die Vertiefung (5) herum eine Auflageschulter (4A) aufweist,
wobei das Trägerelement (2) so in den Kartenkörper (1A) eingesetzt wird, daß das erste Teil (2A) mittels der Heißklebeschicht (6) auf der Auflageschulter (4A) fixiert wird und das zweite Teil (2B) in der Vertiefung (5) Platz findet,
dadurch gekennzeichnet, daß
in einem ersten Schritt vor dem Einsetzten des Trägerelements (2) in die Vertiefung (5) des Kartenkörpers (1A) mittels eines Dispensers (9) ein zusätzlicher Kleber (7) zur Verbindung des Vergußgehäuses (2B) mit dem Kartenkörper (1A) eingebracht wird, und dann in einem zweiten Schritt das Trägerelement (2) mittels Druck und Wärme in die Aussparung (4) des Kartenkörpers (1A) eingesetzt wird.

2. Verfahren nach Anspruch 1,
dadurch gekennzeichnet, daß
der in dem ersten Schritt in die Vertiefung (5) des Kartenkörpers (1A) einzubringende Kleber (7) im Verarbeitungszustand hochviskos, vorzugsweise gelartig, ist.

3. Chipkarte mit einem in einen Kartenkörper (1A) eingesetzten Trägerelement (Chipmodul),
das aus zwei Teilen (2A,2B) besteht,
- nämlich einem ersten Teil (2A), auf dem elektrische Kontaktflächen (20) für die Energieversorgung und den Datenaustausch des Chips (IC-Halbleiterbaustein) mit externen Geräten angeordnet sind,
- und einem zweiten Teil (2B) in Form eines Vergußgehäuses, das den Chip (3) und die Anschlußleitungen (30) des Chips (3) an die Kontaktflächen (20) aufnimmt und vor mechanischen Belastungen schützt, wobei der erste Teil (2A) über den Rand des zweiten Teils (2B) hinausragt
- wobei das Trägerelement (2) auf der den Kontaktflächen (20) gegenüberliegenden Seite zumindest in dem Bereich, wo das erste Teil (2A) das zweite Teil (2B) randseitig überragt, eine Heißklebeschicht (6) aufweist,
wobei der Kartenkörper (1A) eine Aussparung (4) mit einer mittig dazu liegenden Vertiefung (5) aufweist, und die Aussparung (4) um die Vertiefung (5) herum eine Auflageschulter (4A) aufweist,
wobei das Trägerelement (2) so in den Kartenkörper (1A) eingesetzt ist, daß das erste Teil (2A) mittels der Heißklebeschicht (6) auf der Auflageschulter (4A) fixiert wird und das zweite Teil (2B) in der Vertiefung (5) Platz findet,
dadurch gekennzeichnet, daß
innerhalb der Vertiefung (5) des Kartenkörpers (1A) ein zusätzlicher Kleber (7) zur Verbindung des Vergußgehäuses (2B) mit dem Kartenkörper (1A) eingebracht ist.
